# EUROPEAN PATENT APPLICATION

(11) **EP 1 876 657 A1**
(43) Date of publication of application: **09.01.2008**
(21) Application number: 06014119.9
(22) Date of filing: 07.07.2006
(51) Int. Cl.: H01L 51/40

(54) **Process for making patterned conductive layers**

(71) Applicant: CSEM Centre Suisse d'Electronique et de Microtechnique SA, 2007 Neuchâtel (CH)
(72) Inventor: Beierlein, Tilman, 8802 Kilchberg (CH); Walter, Harald, 8802 Kilchberg (CH)
(74) Representative: Blum, Rudolf Emil

(57) **Abstract**

The present invention relates to processes for patterning of conductive layers, to the use of materials useful in such processes and to electronic devices obtained by such processes.

## Description

The present invention relates to processes for patterning of conductive layers, to the use of materials useful in such processes and to electronic devices, particularly to organic light-emitting devices (OLED), obtained by such processes.

The fast development of electronic device technology increased the need for cheap but reliable methods for the deposition of the layer stacks as well as for the patterning of the layers.

One way to achieve cost-effectiveness in the manufacture of electronic devices is to use large area fabrication methods such as Roll-to-Roll (R2R) printing on polymeric supports.

A typical process for OLED fabrication comprises: i) Deposition and patterning of the bottom electrode (usually the anode), ii) Deposition and patterning of the organic layers and iii) Deposition and patterning of the top electrode (usually the cathode). Especially the patterning of the conductive layers, i.e. the anode and the cathode layer in case of an OLED, are regarded as crucial process steps. For the bottom electrode of OLEDs typically Indium-Tin Oxide (ITO) is used which is usually patterned via photolithography and etching or via embossing (see e.g. WO 04111729A1) . The organic layers can be directly deposited with the desired pattern via various printing methods, e.g. gravure-, inkjet- or screen printing. The top electrode is usually deposited by vacuum evaporation and patterned via shadow masks.

A number of processes for patterning a conductive layer of an electronic device are known. Some methods are useful for patterning of conductive layers which are deposited directly on the support. Methods for patterning conductive layers which are on top of a layer stack of electronic devices are more difficult. At present mainly lithography is used. This method comprises several steps for the patterning including critical subtractive process steps. In general, for the patterning of layers or layer stacks in electronic devices some techniques are described in the literature. These include etching, printing, use of shadow masks, embossing and use of separator structures, which are summarized below.

Etching of the conductive layer, e.g. a metal or transparent conductive oxide layer, is one of them. First of all a protective layer, a so-called resist, is deposited on the layer to be patterned. The desired pattern is then created in the resist layer e.g. by photolithography followed by a development step. If only low resolution is needed the resist layer can be patterned printed. In both cases the pattern can than be transferred in the conductive layer by a wet or dry etching step which removes the unprotected areas. After the etching step the residual resist must be removed. The big advantage of this technique is the high resolution of the photolithography process (down to 65nm). The multiple steps of the process which make it very slowly and costly are considered the main drawback of this method. Furthermore, etching processes are critical for many organic materials as well as for a number of polymeric supports, the barrier coatings and injection layers (e.g. Barium Ba or Calcium Ca). Thus, this technique is not well suitable for roll-to-roll production of electronic devices.

Printing processes are capable of producing patterned layers. Even conducting polymers like Poly(3,4-ethylenedioxythiophene) poly(styrenesulfonate) (PEDOT:PSS) can be printed with high speed in roll-to-roll processes e.g. by gravure printing. Inks containing conducting particles like metal nanoparticles (e.g. Ag, Al, Au) or indium tin oxide (ITO) are likewise possible. The limitation of the resolution of the printing processes is considered as a drawback of the printing approach. Especially patterned layers about 100nm thick with a well defined thickness at the edges of the pattern are difficult to realise. Further, the conductivity and the injection properties - needed for a cathode layer - of printed conducting inks are less suitable to electronic devices than vacuum deposited double layer stacks (e.g. Ca and Al).

Patterned deposition of conductive layers through shadow masks is a fast and economic technique. It can be used in vacuum deposition techniques such as evaporation or sputtering even in a roll-to-roll coater. The drawback of this technique is the limited resolution of larger than 200µm. Further in roll-to-roll processes there is a restriction to simple patterns consisting only of lines parallel to the web direction.

Methods for patterning of layers based on die-cutting, embossing and the like are described e.g. in WO 01/60589 A1, US2005/0071969 A1 and WO2004/111729 A1. The permanent deformation of the support which causes a loss in the barrier properties is considered as a drawback of this approach. Besides a patterning of a conductive layer (e.g. the cathode) on top of the layer stack of an electronic device by embossing will transfer the identical pattern into the other conductive layer (e.g. anode) which is placed below the organic active layer or layer stack. However, usually different patterns for the bottom and top electrodes are needed.

A widely used method to pattern the conductive layer on top of the organic layer stack is to place so called separator structures on the layer stack before depositing the conductive layer. US 5701 055 describes methods for patterning the top electrode of an electronic device. Separator structures are manufactured directly on top of the bottom electrode before deposition of the organic layers and the top electrode layer. The peculiarity of these separators is the overhanging sidewalls. This negative slopes act as support bound shadow masks. They are produced by photolithography. First a light sensitive polymer layer, a resist, is deposited homogeneous on top of the bottom electrode. Next, this layer is illuminated according to the desired pattern. Then a development step removes the unwanted parts of the resist leaving the separator structures unaffected. By tuning the illumination conditions and the development steps negative slope side walls of the separators are obtained. This method is practicable for devices based on small molecule organic layers which are evaporated in vacuum after the manufacturing of the separator structures, whereas with wet-coated polymer layers homogenous film forming is unlikely because of the topology of the separators. A further drawback of this method is the multiple process steps, especially the development step of the photo-resist. A manufacturing of the separator structures after the wet coating of the organic layer or layer stack is no option as the development step damages the organic layer stack and/or the support or the barrier coatings. Due to these drawbacks this method is regarded unsuitable for a roll-to-roll (R2R) process.

Up to now there is a lack of manufacturing processes, in particular of patterning methods, which address all the mentioned points.

Thus, it is an aim of the present invention to provide a process for manufacturing of electronic devices that eliminates and/or overcomes at least some of the drawbacks of the known processes.

The present invention also aims to provide a R2R compatible solution for a patterning method of the top electrode.

This is achieved by a process of patterning at least one conductive layer of an electronic device comprising the steps of: i) patterned deposition of a separator material on a surface and subsequent, ii) deposition of a conductive layer on the obtained surface and subsequent, iii) treatment of the obtained structure to effect a shape change of the separator material for disrupting the conductive layer; or i) patterned deposition of a separator material on a surface and subsequent, ii) treatment of the obtained structure to effect a shape change of the separator material for creating shadowed regions between said separator structure and said surface and subsequent iii) deposition of a conductive layer on the obtained structured surface wherein said separator material prevents deposition of said conductive layer in said shadowed regions.

Advantageously, all steps of these processes are additive, thus no partially or complete removal of one of the materials (e.g. photo resist in case of photolithography) is needed.

Further embodiments of the invention are disclosed in the specification and independent claims, preferred embodiments are disclosed in the dependent claims and the specification.

Unless otherwise stated, the following definitions shall apply in this specification:

"Electronic device" refers to a device comprising a support and at least two electrodes separated by a layer of functional material and optionally further layers. Such devices are known and include, e.g. organic light-emitting devices (OLEDs), organic field-effect transistors (OFETs), organic photocells (OPCs) or other organic sensors. Within the scope of this invention, OLEDs are preferred. Due to the fact that the functional material preferably comprises an organic material (small molecules or polymers), the electronic device is also referred to as "organic device".

"Support" refers to the material supporting the electronic device; such materials are known in the art and in include polymeric material and glass. The appropriate support can be chosen by an expert taking into account the manufacturing process, the conductive material used and the intended use. For example, roll-to-roll processes require the use of flexible polymeric supports.

The term "electrodes" is known in the field; electrodes consist of conductive material. The bottom electrode is the electrode next to the support, while the top electrode is the electrode distant to the support.

"Conductive material" refers to any conductive material known in the art with a sheet resistance smaller than 50kΩ/□; preferably smaller than 100Ω/□. This includes metals such as aluminium, nickel, copper, silver, gold and compositions such as indium tin oxide (ITO). The conductive material is used to form the electrodes of the electronic device. Cathode and anode may be made of the same or different conductive materials. In a preferred embodiment, the lower electrode is made of ITO, while the upper electrode is made of a metal.

"Functional material" refers to the material located between the electrodes or adjacent or close thereto; such materials are known in the art and include polymers as well as small molecules, e.g. adapted to emit light when an electric field is applied thereto, to exhibit nonlinear electrical properties (e.g. to be used in a transistor or a diode), and/or to act as a sensor.

The term "patterning" refers to a process in which a pattern or structure is established on a layer of an electronic device. Typically, the pattern consists of conducting regions mutually separated by electrically insulating regions. Patterning can e.g. be used to create conductor lines on the device.

"Separator material" refers to any isolating material or combination of materials suitable in the manufacturing of electronic devices having the following characteristics: i) capable of an irreversible shape change upon controlled treatment (also referred as shape changing step) during manufacture; ii) (at least partial) adhesion to the surface applied on during manufacture of the device and during its subsequent use; iii) no or tolerable interaction with the functional material. The shape change referred to above results in a change of surface and/or contact angle; it may be a swelling, shrinking, or bending. In any case, such shape change is irreversible during the subsequent manufacturing steps and during use of the manufactured device.

The "controlled treatment" referred to above denotes any treatment that effects a shape change of the selected separator material. Examples of such treatments are heat, irradiation, vacuum or exposure to gas or liquid.

The present invention will be better understood by reference to the figures; a brief description of the figures is given below:
Fig. 1: Schematic view on different structured separator materials on top of the surface of a support A. i) before shape changing; ii) - v) after shape changing. ii) increased volume and positive slope (contact angle below 90°); iii) shrinking; iv) bending v) deformation with negative slope (contact angle above 90°; shadowed regions are marked (S));
Fig. 2: Schematic view on an electronic device before shape change of the structured separator material. (A) Support (B) bottom electrode (C) functional material, (D) separator material, (E) top electrode. This arrangement may be part of an OLED;
Fig. 3: Schematic illustration of two examples of the inventive process; (C) functional material, (D) structured material, (E) top electrode; the arrow indicates the deposition direction for (E);
Fig. 4: microscopic view on the top conductive layer after the manufacturing process: left (light grey) metal of conductive layer, right (dark) separator material; middle separation area.

The present invention will be described in more detail below. It is understood that the various embodiments, preferences and ranges as provided / disclosed in this specification, may be combined at will. Further, depending of the specific embodiment, selected definitions, embodiments or ranges may not apply.

In first aspect, the invention relates to processes of manufacturing at least one patterned conductive layer, in particular for electronic devices.

Electronic devices usually consist of layers having different functions. Typically, such devices are manufactured by establishing the required layers starting from a support, wherein the layers are manipulated to obtain the required structure (or pattern) of said layer to fulfil the purpose of the electronic device. The invention is in particular related to the patterning of conductive layers as used in electronic devices, e.g. organic light-emitting devices (OLEDs), organic transistors (OFET) or organic photocells (OPC). Layers of electronic devices usually have a thickness of about 100 nm.

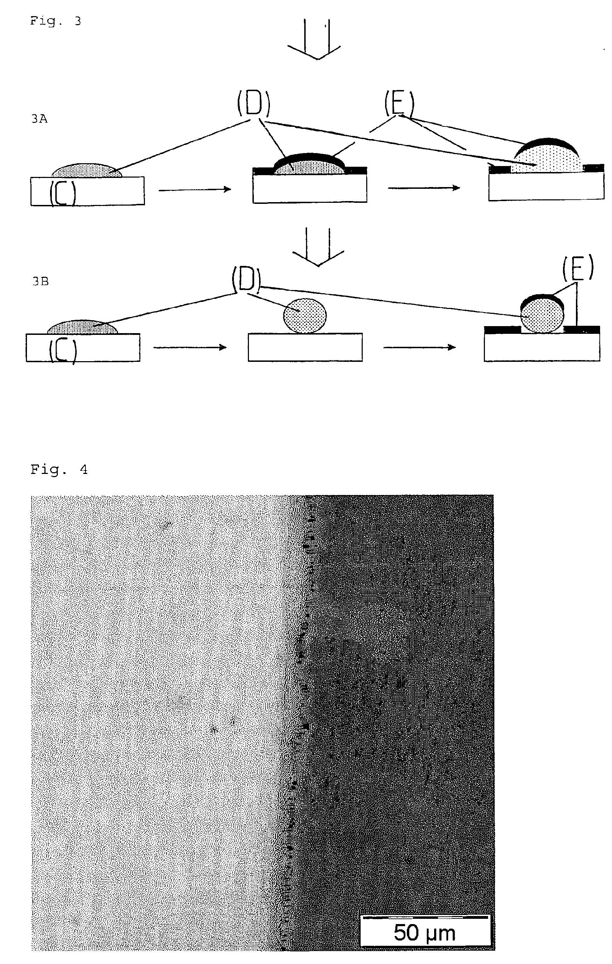

The invention relates to a process of patterning at least one conductive layer of an electronic device comprising the steps of: i) patterned deposition of a separator material on a surface and subsequent ii) deposition of a conductive layer on the obtained surface and subsequent iii) treatment of the obtained structure to effect a shape change of the separator material for disrupting the conductive layer. (c.f. Fig. 3A)

In an alternative embodiment, the invention provides a process of patterning at least one conductive layer of an electronic device comprising the steps of: i) patterned deposition of a separator material on a surface and subsequent, ii) treatment of the obtained structure to effect a shape change of the separator material for creating shadowed regions between said separator structure and said surface and subsequent iii) deposition of a conductive layer on the obtained structured surface wherein said separator material prevents deposition of said conductive layer in said shadowed regions. (c.f. Fig. 3B)

In a further embodiment, the shape change referred to above may be expressed by the change of the contact angle. Thus, the shape change may increase the volume of the separator material leading to an increased contact angle. As the conductive material is less flexible than the separator material, the increased volume (and thus the increased surface) will result in the formation of tears (rents) within the conductive layer.

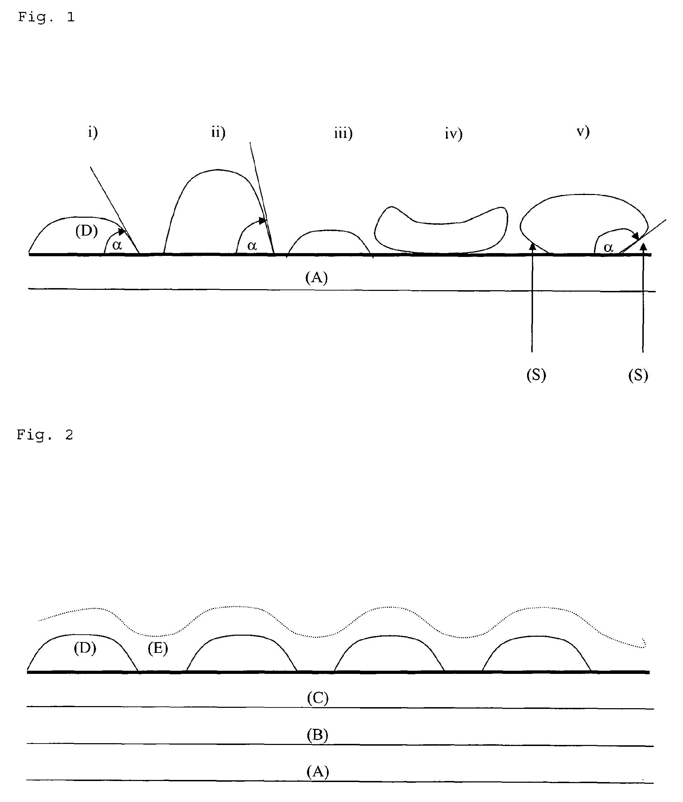

If the resulting contact angle, i.e. the angle α as indicated in Fig. 1, is e.g. above 90°, shadowed regions are formed. When depositing the conductive layer, these regions are "shadowed" from the incoming conductive layer particles or molecules, i.e. a formation of the conductive layer is prevented in the shadowed regions. Thus, in a preferred embodiment, the present invention provides a process of patterning at least one conductive layer of an electronic device comprising the steps of i) patterned deposition of a separator material on a surface and subsequent; ii) treatment of the obtained structure to effect a shape change of the separator material until the contact angle between separator material and support surface is above 90° and iii) deposition of a conductive layer on the obtained structured surface.

In a further embodiment, the invention relates to a process of patterning at least one conductive layer of an electronic device comprising the steps of: i) patterned deposition of a separator material on a surface and ii) subsequent deposition of a functional layer and iii) subsequent deposition of a conductive layer on the obtained surface and iv) subsequent treatment of the obtained structure to effect a shape change of the separator material for disrupting the conductive layer.

In a further embodiment, the invention provides a process for manufacturing an electronic device comprising the steps of (patterned) deposition of a bottom conductive layer on a support and subsequent (patterned) deposition of a functional layer on said bottom conductive layer prior to the steps as outlined above.

In a preferred embodiment, the invention relates to a process of patterning one conductive layer of an electronic device comprising the steps as outlined above.

In a preferred embodiment, the invention relates to a process of patterning one conductive layer which is not in contact with the support of an electronic device comprising the steps as outlined above.

In a preferred embodiment, the invention relates to a process of patterning the top conductive layer of an electronic device comprising the steps as outlined above.

The separator material may be deposited in any manner compatible to the surface where it is deposited on. In a preferred embodiment, the patterned deposition of a separator material is effected by a printing step e.g. by gravure-, screen-, inkjet- or tampon-printing.

In a preferred embodiment, the separator material is mixed with additives to allow a convenient deposition. Such additives may be solvents, dispersants, adhesives, binders and the like.

The separator material is subjected to a shape changing step before or after deposition of the conductive layer, thus leading to a subdivision of the conductive layer (i.e. formation of tears). This treatment is adapted to the separator material used.

The shape changing step is adapted to the separator material used in the process. Such treatment may include heating (e.g. in case of gas-filled spheres, in particular microspheres), contacting with a reactive material (e.g. in the case of poly urethanes) which leads to a chemical reaction, exposing to radiation, such as visible or UV light (e.g. in case of light-sensitive material) or the exposure to reduced pressure (for example, if gas is included in the separator material). In a preferred embodiment, the shape changing step comprises heating.

In a further preferred embodiment, the shape changing step comprises the step of contacting two or more reactants that form foam of increased volume upon contact. This includes, for example, the reaction of an isocyanate component with an alcohol component to form a poly urethane.

The deposition of the conductive layer on the separator structure may be performed in any convenient manner known to the expert and adapted to the whole process. This includes e.g. vacuum evaporation, sputtering, spray-coating, curtain-coating or printing, preferably vacuum evaporation.

Separator materials are known to the expert and include polymers that form gases during polymerisation (e.g. poly urethane foams) and gas filled microspheres (e.g. expancel®, a copolymer consisting of vinylidene chloride, acrylonitrile and methylmethacrylate filled with isobutene/isopentane). In a preferred embodiment, the separator material is selected from the group comprising gas filled microspheres (e.g. expancel®) and poly urethanes.

Suitable supports for the electronic devices are made of glass, polymer (preferably flexible polymeric foil), paper or metal. Flexible supports are well suited for roll-to-roll processes. The supports can be made of acrylonitrile butadiene styrene (ABS), polycarbonate (PC), polyethylene (PE), polyetherimide (PEI), polyetherketone (PEK), poly(ethylene naphthalate) (PEN), poly(ethylene therephtalate) (PET), polyimide (PI), poly(methyl methacrylate) (PMMA), poly-oxy-methylene (POM), mono oriented polypropylene (MOPP), polystyrene (PS(, polyvinyl chloride (PVC) and the like. Other materials like paper (weight per area 20 - 500g/m2, preferably 40 - 200g/m2), metal foil, (for example Al-, Au-, Cu-, Fe-, Ni-, Sn-, steel-foil etc., especially surface modified, coated with a lacquer or polymer, are suitable too. In a further embodiment, the support can be coated with a barrier layer or a barrier layer stack to increase the barrier properties (J. Lange and Y. Wyser, "Recent Innovations in Barrier Technologies for Plastic Packaging - a Review", Packag. Technol. and Sci. 16, 2003, p.149-158). E.g. inorganic materials like SiO₂, Si₃N₄, SiOₓN_{y}, Al₂O₃, AlOₓN_{y} and the like are suitable. They can be deposited e.g. in vacuum processes like evaporation, sputtering or chemical vapour deposition CVD, especially plasma enhanced CVD (PECVD). Other suitable materials are mixtures of organic and inorganic materials deposited in a sol-gel process. Such materials can be deposited e.g. in a wet coating process (like gravure printing). Very good barrier properties are obtained by multilayer coatings of organic and inorganic materials as described e.g. in WO03/094256A2. In the context of this invention the term supports denotes supports with and without barrier coatings.

Suitable materials for conductive layers are known to the expert and include metals like e.g. Al, Ni, Cu, Ag or Au and alloys. The conductive layers can be semitransparent (depending on the metal with a thickness of a few tenth of nanometers up to 50nm) or opaque (thickness of >50nm). Other suitable materials are transparent conductive oxides (TCO) like e.g. ITO, aluminium doped zinc oxide (AZO) or gallium doped zinc oxide (GZO). Typical thickness of such a TCO layer is in the range of 50nm up to 200nm. Due to a distinct increase of the stress in inorganic layers above a thickness of roughly 200nm (depending on deposition method and parameter) typical values of the conducting layers are below that threshold. The conductive layers of an electronic device may be made of the same or different materials. In one embodiment, the upper electrode is made of semitransparent material.

Suitable functional materials are known to the expert. Examples are PEDOT:PSS, tris-(8-hydroxyquinoline) aluminum (Alq3), poly(phenylene vinylene) PPV or poly(fluorene) PF. Such functional materials may contain auxiliaries, such as solvents, fillers, adhesives and the like.

The process as described above is in particular suitable for the mass-production of OLEDs OFETs and OPCs; preferably for the manufacture of OLEDs.

The process as described above is in particular suitable for electronic devices wherein the functional layer comprises small molecules, as such devices are particular sensitive towards the hereto known manufacturing processes.

Further, the process as described above may be part of a continuous process, such as an R2R fabrication process.

To further illustrate the processes as outlined above, reference is made to figures 2 and 3
First process (see Fig. 3A):
   1) Patterned deposition of a separator material (an electrically insulating layer) e.g. by gravure-, screen-, inkjet- or tampon-printing. The pattern defines the desired separation pattern of the electrode layer.
   2) Deposition of the conductive layer, e.g. via vacuum evaporation, sputtering, spray, curtain-coating, or printing.
   3) Shape changing step of the separator material caused e.g. by heat, irradiation, vacuum, gas treatment, wherein the shape change separates the conductive layer into electrically isolated parts.
Second process (see fig. 3B):
   1) Patterned deposition of a separator material (an electrically insulating layer), e.g. by gravure-, screen-, inkjet- or tampon-printing. The pattern defines the desired separation pattern of the electrode layer.
   2) Shape changing step of the separator material caused, e.g. by heat, irradiation, vacuum, or gas treatment which creates a structure with a negative slope.
   3) Deposition of the conductive layer, e.g. via vacuum evaporation, sputtering, spray-coating, or printing, wherein this layer is separated due shadow effect of the negative slope side-walls of the separator into electrically isolated parts.

In a second aspect, the invention relates to the use of specific materials or compositions for use as separator materials as described herein.

Thus, the invention relates to the use of expancel® and/or polyurethane for manufacturing electronic devices, in particular to manufacturing processes as described herein.

In a third aspect, the invention relates to electronic devices, in particular to electronic devices obtainable by a process as described herein.

Thus, the invention relates to an electronic device comprising a support, a lower electrode; a functional material, a patterned separator material and an upper electrode, wherein the upper electrode is disrupted by tears formed upon shape change of the separator material.

In a preferred embodiment, the invention relates to an electronic device as describe above wherein the separator material comprises gas filled spheres. Advantageously, the spheres are of a thermoplastic material that becomes softer at elevated temperatures. Heating such a separator material causes the internal pressure within the spheres to expand the spheres.

In a preferred embodiment, the invention relates to an electronic device as describe above wherein the device is selected from the group consisting of OLEDs OFETs and OPCs.

In a further aspect, the invention relates to the use of electronic devices in electrical equipment.

The invention will now be described by way of an example. This example is meant to illustrate the invention, with no intent to a limitation.

300 mg of Expancel® 461DU20 (Akzo Nobel) are mixed with 1ml Prima-Eco 16(Brenntag specialities, Christ Chemie AG). Thin lines having a width of about 200µm and a specific mass of 15µg/m of the obtained mixture are applied to a glass support by means of printing. The obtained structure is then coated with Aluminium by means of thermal evaporation. The resulting metal layer has a thickness of 70nm. After heating for 10 seconds at 120°C, which is the shape changing step as defined in this specification, a tearing of the upper aluminium layer is observed as depicted in Fig. 4. The left-hand part of the microscope image shows the flat metal layer and the right-hand side part is the separator line. In-between the electrically separating gap is visible.

## Claims

1. A process of patterning at least one conductive layer of an electronic device comprising the steps of:
• patterned deposition of a separator material on a surface and subsequent
•deposition of a conductive layer on the obtained surface and subsequent
•treatment of the obtained structure to effect a shape change of the separator material for disrupting the conductive layer
or
• patterned deposition of a separator material on a surface and subsequent
•treatment of the obtained structure to effect a shape change of the separator material for creating shadowed regions between said separator structure and said surface and subsequent
•deposition of a conductive layer on the obtained structured surface wherein said separator material prevents deposition of said conductive layer in said shadowed regions.

2. A process according to claim 1 comprising the steps of:
•patterned deposition of a separator material on a surface and subsequent
•deposition of a conductive layer on the obtained surface and subsequent
• treatment of the obtained structure to effect a shape change of the separator material for disrupting the conductive layer
wherein said separator material comprises gas filled spheres and
wherein said treatment of the obtained structure to effect a shape change comprises the step of heating.

3. A process of any of the preceding claims wherein said separator material comprises a thermoplastic material.

4. A process according to claim 1 comprising the steps of:
• patterned deposition of a separator material on a surface and subsequent
• treatment of the obtained structure to effect a shape change of the separator material for creating shadowed regions between said separator structure and said surface and subsequent
• deposition of a conductive layer on the obtained structured surface wherein said separator material prevents deposition of said conductive layer in said shadowed regions.
wherein said separator material comprises a poly urethane and
wherein said treatment of the obtained structure to effect a shape change comprises the step contacting the isocyanate component with the alcohol component.

5. A process according to any of the preceding claims wherein the patterned deposition of the separator material is effected by a printing step.

6. A process according to any of the preceding claims wherein the deposition of a conductive layer is effected by vacuum evaporation or sputtering.

7. A process according to any of the preceding claims wherein the electronic device comprises a support made of,a flexible material.

8. An electronic device comprising a support, a lower electrode; a functional material, a patterned separator material and an upper electrode, wherein the upper electrode is disrupted by tears formed along the separator material.

9. An electronic device according to claim 7 wherein the separator material comprises gas filled spheres, in particular of a thermoplastic material.

10. An electronic device of any of the claims 7 or 8 wherein the device is selected from the group consisting of OLEDs, OFETs and OPCs.

11. An electronic device obtainable by a process according to any of the claims 1 to 6.

12. The use of a separator material for manufacturing an electronic device by incorporating said separator material into said device to form a structure on a surface and by treating the obtained structure to effect a shape change of the separator material i) for creating shadowed regions between said separator structure and said surface or ii) for disrupting the conductive layer.
